# EUROPEAN PATENT SPECIFICATION

(11) **EP 0 503 892 B1**
(45) Date of publication and mention of the grant of the patent: **13.05.1998**
(21) Application number: 92302024.2
(22) Date of filing: 10.03.1992
(51) Int. Cl.: H01L 27/20, H03B 5/32, H03B 5/36, H03H 9/19

(54) **High-frequency apparatus using quartz crystal resonator and its production method**
Hochfrequenz-Vorrichtung unter Verwendung eines Quartz-Kristall-Resonators und deren Herstellungsmethode
Dispositif à hautes-fréquences utilisant un résonateur à cristal de quartz et sa méthode de fabrication

(30) Priority: 13.03.1991 JP 47872/91
(43) Date of publication of application: 16.09.1992
(73) Proprietor: MATSUSHITA ELECTRIC INDUSTRIAL CO., LTD., Kadoma-shi, Osaka-fu 571 (JP)
(72) Inventor: Eda, Kazuo, Nara-shi, Nara-ken 631 (JP)
(74) Representative: Crawford, Andrew Birkby

(56) References cited:
- APPLIED PHYSICS LETTERS. vol. 37, no. 11, 1 December 1980, NEW YORK US pages 993 - 995; T.W.GRUDKOWSKI ET AL.: 'Fundamental-mode VHF/UHF minitiature acoustic resonators and filters on silicon'
- IEEE TRANSACTIONS ON MICROWAVE THEORY AND TECHNIQUES. vol. 34, no. 10, October 1986, NEW YORK US pages 1002 - 1016; E.A.GERBER ET AL.: 'Advances in microwave
- acoustic frequency sources'
- ELECTRONICS. vol. 54, no. 14, July 1981, NEW YORK US R.GALLAGHER: 'Direct- frequency crystal oscillator line extends to 1.5 GHz' page 7E-8E
- JOURNAL OF APPLIED PHYSICS. vol. 60, no. 8, 15 October 1986, NEW YORK US pages 2987 - 2989; M.SHIMBO ET AL.: 'Silicon-to-silicon direct bonding method'

## Description

This invention relates to a high-frequency apparatus such as a voltage controlled oscillator, temperature compensated quartz crystal oscillator, high-frequency receiving apparatus and the like, in which a quartz crystal resonator is used as an oscillating resonator or a high-frequency filter, and its structure and production method particularly in order to make the same small in size and weight, high in performance and low in cost.

### Description of the Prior Art

A conventional voltage controlled oscillator using an electro-mechanical resonator such as a quartz crystal resonator has been made of an active element (transistor) for generating oscillation, a quartz crystal resonator for generating the oscillation at a desired frequency, a variable capacitance diode whose capacity can be varied by voltage, and some chips of electric component part including a capacitor, resistance and the like. Generally, such quartz crystal resonator to be used as above is sealingly housed into a container such as a metal tube and the like for preventing an adverse effect from the environment in order to provide a performance to be stably effected for a long period of time. For this purpose, however, the size of a quartz crystal resonator is unavoidably made several times that of the quartz crystal itself. As a result, the voltage controlled oscillator prepared by such a method that a large-sized quartz crystal resonator and related-component parts are individually provided on a substrate unavoidably becomes large in size and weight, so that there arises such a problem that it is not preferable to be used for various devices including an automobile telephone system and portable telephone system that compactization is made the most essential subject.

The automobile telephone system, portable telephone system or the like uses a frequency of pseudo-microwave band, for example, ranging from 800 MHz to 1.5 GHz. In order to obtain such a resonator as is high in frequency as shown above, it is required to make the thickness of the quartz crystal resonator small by a polishing or etching method. For example, the fact that a quartz crystal film was polished up to a thickness of 10 microns (µm) by a fine polishing method thereby to oscillate a frequency of about 500 MHz has been reported by A. Lepket and others in their report titled as "A New Design For High Frequency Bulk Resonators", 43rd Annual Symposium on Frequency Control (1989), pp. 544 to 547. However, the use of a resonator whose thickness is made 10 µ m or less becomes extremely difficult to be retained or handled from the viewpoint of mechanical strength as well as to be produced on a mass-production basis. Accordingly, it is extremely difficult to obtain a voltage controlled oscillator of a high-frequency as to exceed 500 MHz by substantially using the fundamental oscillation mode of a quartz crystal resonator. Use of a high-order oscillation mode results in a reduction in Q factor of resonance, so that to obtain a highly performable and stable oscillator was also difficult previously.

As a method of producing a voltage controlled oscillator which is simultaneously attainable the targets of compactization and high-frequency oscillation, for example, the following has been reported by Grudkowski and others in their report titled as "Fundamental-mode VHF/UHF Miniature Acoustic Resonators and Filters on Silicon", Applied Physics Letters Vol. 37 (11) (1980), pp. 993 to 995, in which a ZnO thin film resonator is formed on a silicon substrate thereby preparing a resonator to be used in the pseudo-microwave frequency range.

In this case, such a resonator that has a thickness of several microns can be easily formed, so that it will become possible to obtain a resonator of pseudo-microwave frequency band. However, the ZnO thin film is considerably inferior in dependence of resonance frequency on temperature as well as in Q factor of resonance to the quartz crystal one, which means that the former is not sufficient on a performance basis as compared with the latter.

These disadvantageous aspects constitute common problems to be solved for various high-frequency apparatus using a quartz crystal resonator including a temperature compensated quartz crystal oscillator, and various high-frequency receiving devices using a quartz crystal resonator as a frequency filter.

An object of this invention is to provide various high-frequency apparatus using a quartz crystal resonator including a voltage controlled oscillator, a temperature controlled quartz crystal oscillator, a high-frequency receiving device and the like, which are small in size, light in and weight, high in performance and low in cost.

The present invention provides a high-frequency apparatus comprising a quartz crystal resonator which is directly bonded to a silicon semiconductor substrate by coupling of oxygen and silicon or by coupling of hydrogen or hydroxyl groups whereby the quartz crystal resonator is integrated in a unitary body with the substrate.

The present invention also provides a high-frequency apparatus comprising a quartz crystal resonator which is bonded to a semiconductor substrate via a glass whereby the quartz crystal resonator is integrated in a unitary body with the substrate.

Fig. 1 schematically cross-sectionally shows a first embodiment of this invention.

Fig. 2 schematically cross-sectionally shows a second embodiment of this invention.

Fig. 3 schematically cross-sectionally shows a third embodiment of this invention.

Preferred embodiments of this invention will be made below on a structure and production method of a voltage controlled oscillator using a quartz crystal resonator while referring to the drawings attached.

### (First Embodiment)

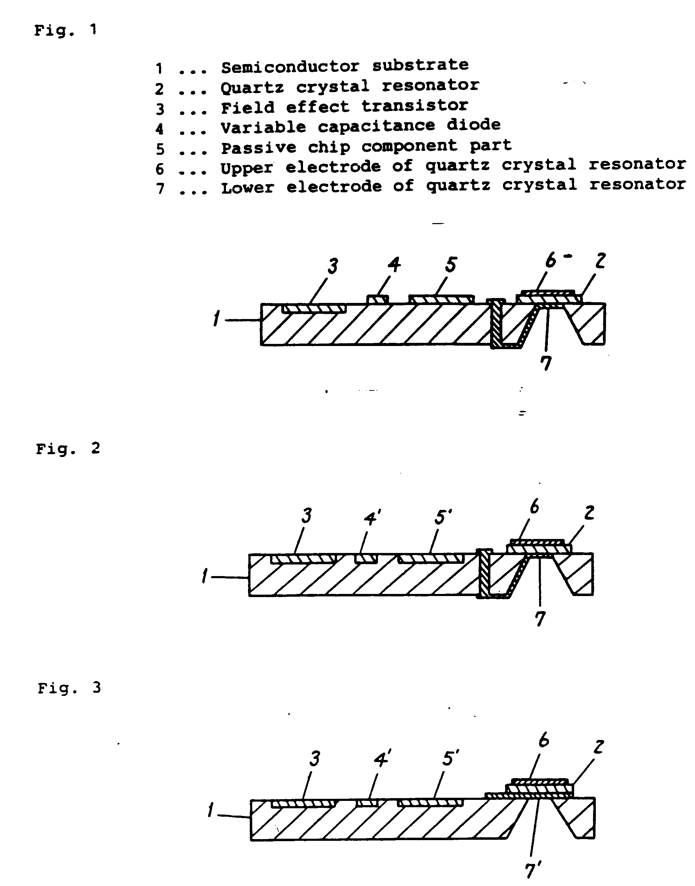

A voltage controlled oscillator according to a first embodiment of this invention is cross-sectionally shown in Fig. 1. In Fig. 1, the reference numeral 1 indicates a semiconductor substrate made, for example, of silicon, 2 does a quartz crystal resonator directly bonded onto the semiconductor substrate 1, 3 does a field effect transistor (FET) formed on the semiconductor substrate 1, 4 does a variable capacitance diode chip, 5 does a passive chip component part such as a capacitor, an inductor, a resistor and the like, 6 does an upper electrode of the quartz crystal resonator 2, and 7 does a lower electrode of the quartz crystal resonator 2. The electrical connection of the lower electrode of the resonator and the wiring formed on the semiconductor substrate is made through such a via-hole method that a hole is perforated through the substrate and filled with an electroconductive material thereby electrically connecting the lower electrode to the wiring on the substrate. The component parts formed on the semiconductor substrate and the upper and lower electrodes of the quartz crystal resonator are respectively electrically connected so as to make a voltage controlled oscillator. Such a voltage controlled oscillator as is integrated in a unitary body as shown above is sealingly contained into a container for keeping its environment resistant performance stably. The field effect transistor, the various electrical component parts and the quartz crystal resonator constitute an oscillator. By varying a voltage to be applied to the variable capacitance diode, the capacitance thereof can be varied, and the oscillation frequency can be varied. By structuring as shown above, the oscillation circuit section and the quartz crystal resonator can be integrated in a unitary body, so that it is made possible to make the size outstandingly small as compared with conventional ones. In addition, as compared with conventional ones having a quartz crystal resonator sealing contained into a container individually provided, the apparatus of the invention can be reduced to about one-tenth on a volume basis and to about one-fifth on a weight basis.

If the direct bonding is made with a bonding material to be used for general resin or the like, there may arise such a problem that various fine processings such as the formation of electrodes and the like to be carried out thereafter cannot be performed. In this case, however, if the method according to this invention is used, the semiconductor substrate and the quartz crystal (single crystal of silicon oxide), particularly when silicon is used as the semiconductor substrate, are bonded to each other by reacting oxygen and silicon on the surface of the quartz crystal with silicon on the surface of the semiconductor substrate. As a result, there does not arise such a problem that is pointed out in case that the bonding is made between inorganic substrate and an organic resin, because this invention uses bonding between inorganic materials. In case of using a resin binder, there exists a large difference between the thermal expansion coefficient of a resin, which is an organic material, and that of a semiconductor substrate, which is an inorganic material, so that there may arise problems on reliability of oscillator on a long period of time basis due to mechanical stress and thermal stability of the resin itself to be used. On the other hand, this invention bonds it directly onto the semiconductor substrate, so that such problems could be overcome.

### (Second Embodiment)

Fig. 2 is a schematically cross-sectional view of a voltage controlled oscillator according to a second embodiment of this invention. In Fig. 2, 1 is a semiconductor substrate made, for example, of silicon, 2 is a quartz crystal resonator bonded directly onto the semiconductor substrate 1, 3 is a field effect transistor (FET) formed on the semiconductor substrate, 4' is a variable capacitance diode whose capacitance can be varied by varying voltage, 5' is a passive chip component part such as a capacitor, an inductor, a resistor and the like, 6 is an upper electrode of the quartz crystal resonator 2, and 7 is a lower electrode of the quartz crystal resonator 7. The upper and lower electrodes of the quartz crystal resonator and the component parts formed on the semiconductor substrate are respectively electrically connected so as to make a voltage controlled oscillator. The voltage controlled oscillator thus integrated in a unitary body is sealingly contained into a container. This embodiment is different from the first embodiment in that the variable capacitance diode 4' and the passive chip component part 5' are embeddedly formed into the semiconductor substrate to make a unitary body. The variable capacitance diode is easy to be formed integratedly with the semiconductor substrate when the substrate is made of silicon. In addition, referring to the passive chip component part 5', the resistor can be easily obtained as a semiconductor resistor, a thin film resistor of tantalum nitride or the like formed by a diffusion method, the capacitor could be easily formed as a silicon oxide thin film, and the inductor could be easily obtained by forming the wiring pattern in a spiral form. As a result, the oscillator of this embodiment can be more easily compactized than that of the first embodiment, and there does not need to take a time for packaging chip component parts, resulting in an ease in mass-production.

### (Third Embodiment)

Fig. 3 schematically cross-sectionally shows a voltage controlled oscillator according to a third embodiment of this invention, in which 1 is a semiconductor substrate, 2 is a quartz resin resonator bonded directly onto the semiconductor substrate 1, 3 is a field effect transistor (FET) formed on the semiconductor substrate 1, 4 is a variable capacitance diode chip whose capacitance can be varied by voltage, 5 is a passive chip component part such as a capacitor, an inductor, a resistor and the like, 6 is an upper electrode of the quartz crystal resonator, and 7' is a lower electrode of the quartz crystal resonator. The oscillator of this embodiment is different from those of the first and second embodiments in that the lower electrode 7' is formed before the direct bonding of the quartz crystal resonator to the semiconductor substrate and connected to the electrode formed on the semiconductor substrate when the resonator is bonded thereto.

The upper and lower electrodes of the quartz crystal resonator thus formed are electrically connected as to make a voltage controlled oscillator. In addition, the voltage controlled oscillator thus integrated in a unitary body was sealingly contained into a container. With the oscillator thus obtained, the same effects as those in the first and second embodiment can be obtained.

### (Fourth Embodiment)

A production method of a voltage controlled oscillator according one embodiment of this invention will be described below as a fourth embodiment.

First, a silicon semiconductor substrate is subjected to fine processes including a semiconductor process, which are to be carried out at a temperature of 870°C R more, at predetermined positions. For example, a FET and a variable capacitance diode were formed at their predetermined positions by a diffusion processing method or the like, which is carried out at a temperature as high as 1000°C or more in general. Next, a quartz crystal resonator is superposingly placed on the semiconductor substrate thus processed and heated at 860°C or less, thereby bonding the quartz to the silicon. In order to etch the substrate only in a part of area beneath the quartz crystal resonator leaving an area necessary for holding the resonator, the remaining area is covered by applying a photoresist or the like and then, subjected to an etching process, thus removing only the silicon in the part of the area beneath the resonator except the area necessary for holding the resonator. Next, the semiconductor processes including the formation of electrodes are carried out, then or thereafter, an electrode is formed on each of the both surfaces of the quartz crystal resonator by a vacuum deposition method or the like, and a wiring is patterned by a generally used photolithographic method. Referring to the heating temperature, for example, at a temperature of 800°C, the bonding is made possible by holding for about ten minutes at that temperature. If it exceeds 860°C, the crystal structure of quartz is changed, and the performance of a quartz crystal resonator cannot be obtained as to be predetermined. As a result, the heating temperature for bonding is required to be 860°C or less. Even at a comparatively low temperature, the direct bonding is made possible, for example, even at a temperature as low as 300°C, when held for about one hour at that temperature, the bonding strength at a sufficient level is obtained. As a result, as the heat treatment temperature for the direct bonding, it is preferable to range from 300 to 800°C. In addition, by applying a pressure onto the bonding surface by such a method that an suitable weight is placed thereon while heat-treating, the bonding strength can be increased. In this case, as the pressure to be applied, it is preferable to range from 100 g/cm² to 10 Kg/cm².

The bonding of the quartz and silicon is considered to be caused by a mechanism similar to the direct bonding mechanism, that is, silicon-to-silicon direct bonding, which was revealed by M. Shimbo and others in their report titled as "Silicon to Silicon Direct Bonding Method", Journal of Applied Physics, Vol. 60 (1986), pp. 2987 to 2989. In other words, the bonding is considered to be taken place at such an atomic level that by the heat treatment, oxygen and silicon atoms on the surface of the quartz crystal, which is a single crystal silicon oxide, are bonded mutually with silicon atoms on the surface of the silicon substrate.

### (Fifth Embodiment)

Another production method of a voltage controlled oscillator according to one embodiment of this invention will be described below as a fifth embodiment.

As in the fourth embodiment, first, a silicon semiconductor substrate is subjected to such semiconductor processes as to be carried out at a temperature of 870°C or more at the predetermined positions. For example, a FET and a variable capacitance diode are formed at their predetermined positions by a diffusion processing method or the like. Then, a quartz crystal resonator is superposingly placed on the silicon semiconductor substrate thus processed and heated thereby directly bonding the quartz of the resonator and the silicon of the substrate. Thereafter, the quartz crystal resonator thus bonded is thinned by a polishing or etching method. By applying this method, a quartz crystal resonator having an initial thickness of about 200 µm is easily thinned to a thickness of 5 µm or less. By further applying a fine etching method thereto, it can be further thinned, thus even a thickness as small as 1 µm being realizable. In case of using quartz crystal AT cut, if it is about 1 µ thick, a fundamental wave oscillation is made possible at a frequency level of about 1 to 2 GHz. Next, by applying the same processes as in the fourth embodiment, it is made possible to produce a voltage controlled oscillator having the semiconductor substrate and the quartz crystal resonator integrated in a unitary body with each other. With the voltage controlled oscillator thus produced, the fundamental wave mode is made possible at such a high-frequency level of 2 GHz as not to be obtainable conventionally.

### (Sixth Embodiment)

Further another production method of a voltage controlled oscillator according to one embodiment of this invention will be described below as a sixth embodiment.

As in the fourth embodiment, first, a silicon semiconductor substrate is subjected to such semiconductor processes as to be carried out at a temperature of 870°C or more at the predetermined positions. Next, the silicon and a quartz crystal resonator are bonded to each other with a low melting-point glass under the application of a heat and pressure. That is, fine glass powder is painted in a paste-like form in the area of the silicon substrate where to be bonded thereto, then, the quartz crystal resonator is superposingly placed in that area, and heated to melt the glass at its melting point, and thereafter, cooled, thus the bonding of the semiconductor substrate and quartz crystal resonator is obtained. The quartz crystal resonator can be bonded thereto by the gravitational effect of its own weight, however, the uniformity of the bonding could be improved by applying a pressure at a level of 100 g/cm² to 1 kg/cm² by such a method that a sufficient weight is placed at the area where to be bonded to each other. Next, as in the fifth embodiment, the quartz crystal resonator is thinned by a polishing or etching method as desired. Then, by applying the same processes as in the fourth embodiment, it is made possible to produce a voltage controlled oscillator having the semiconductor substrate and the quartz crystal resonator integrated in a unitary body with each other as well as to obtain the same effects as obtained in the fourth embodiment. As the low melting-point glass to be used, for example, it may be a borosilicate-lead glass, such one that ranges in melting-point from 300 to 800°C can be selected, so that the bonding temperature can be arbitrarily selected to a certain degree.

### (Seventh Embodiment)

Still further another production method of a voltage controlled oscillator according one embodiment of this invention will be described below as a seventh as a seventh embodiment.

As in the fourth embodiment, first, a silicon semiconductor substrate is subjected to semiconductor processes at the predetermined positions. Next, the surface of the silicon substrate and the surface of a quartz crystal resonator are thoroughly cleaned. That is, each of them is repeatedly boiled with an organic solvent in order to remove any contaminants on the surface. Next, the silicon substrate is subjected to an etching process for removing the silicon surface layer with a mixing solution of hydrogen peroxide and ammonia. The quartz crystal resonator is subjected to removal of the surface layer with an etching solution of the hydrofluoric acid system. Then, the surfaces of the both are rinsed with pure water and superposed uniformly as soon as possible after rinsing, thus the both are capable of bonding to each other easily. Next, the quartz crystal resonator is thinned by applying a polishing or etching method as desired in the same way as in the fifth embodiment. Thereafter, by being subjected to the same processes as in the fifth embodiment, a voltage controlled oscillator having the semiconductor and the quartz crystal resonator integrated in a unitary body with each other is made possible to be produced, thus being obtainable the same effects as those in the fourth and fifth embodiments. The production method shown in this embodiment allows the bonding to be carried out at room temperature. As a result, it can be carried out after all processes have been performed. In this case, it is considered that the silicon substrate and the quartz crystal resonator are bonded to each other with the hydroxyl group or the hydrogen adhered onto the silicon surface and quartz surface, which means that the surface treatment of the substrate is extremely important. In addition, by further heat-treating the specimen thus bonded at a temperature of 860°C or less, the bonding strength can be further improved.

In the first and second embodiments, the lower electrode of the quartz crystal resonator is electrically connected onto the surface of the semiconductor substrate through the via-hole perforatedly provided therethrough. However, it may be structured so that the lower surface of the semiconductor substrate becomes a common ground electrode. In this case, the via-hole does not need to be provided.

In each embodiment, the voltage controlled oscillator was exemplified as the preferred embodiment, however, when a temperature compensated quartz crystal oscillator is to be taken as an embodiment, it can be produced in the same way as to be already explained above and obtained the same effects as those shown above even if a temperature detection circuit and a control circuit for feeding the detected temperature back to a oscillating circuit are additionally provided to a circuit of each embodiment as a chip component part. In addition, using the quartz crystal resonator as a resonance type frequency filter and structuring an amplification apparatus of a high-frequency receiving circuit can be obtained, which also can be obtained the same effects as those shown in the above-described embodiments. In other words, such effects as to be small in size and weight, high in performance and low in cost can be obtained.

This invention comprises the structures and production methods as described above and provides the effects as follows:

In each embodiment, what is to be pointed out first as an effect is that a transistor and quartz crystal resonator which constitute a basic component element for generating oscillation are integrated in a unitary body with each other, so that a high-frequency apparatus such as a voltage controlled oscillator and the like can be made extremely small in size and weight, and as compared with a conventional one using a quartz crystal resonator being sealingly contained into a container, it can be reduced to abut one-tenth on a volume basis and to about one-fifth on a weight basis.

Also, by applying a polishing or etching process to the quartz crystal resonator as shown, for example, in the fifth embodiment, it can be easily thinned up to a thickness of 5 µm or less, which means that such a voltage controlled oscillator that allows the fundamental wave oscillation to be taken place at a pseudo-microwave frequency range (ranging from several hundreds MHz to several GHz), which is difficult to be realized in the prior art, can be easily formed, thus being capable of high performance and low cost.

The bonding methods used in the fourth and fifth embodiments each has nothing to use other than the semiconductor substrate and the quartz crystal resonator, resulting in the direct bonding, so that the oscillating frequency can be easily designed and set. The surface flatness to be obtained when the polishing or etching technique is performed for the quartz crystal resonator depends on the surface flatness of a silicon wafer and surface flatness of a quartz crystal wafer, which means that the precision thereof can be kept at an extremely high level because the both are of a single crystal, so that the controllability of frequency was extremely high.

According to the sixth embodiment, the degree of freedom of the bonding temperature can be obtained, which is preferable on a production process basis.

According to the seventh embodiment, the degree of freedom of the production process can be increased due to the possibility of the bonding at room temperature, which is also preferable on a production process basis.

According to the embodiments shown above, the bonding of the semiconductor substrate and the quartz crystal resonator does not use an organic material which is largely different in the thermal expansion coefficient from the semiconductor substrate and quartz crystal resonator, but does use an inorganic material, which means that the thermal reliability and stability are outstandingly superior. In addition, in the case when the semiconductor substrate and quartz crystal resonator are to be directly bonded to each other, it is achieved with silicon, which is a common element to each other, and either oxygen or hydrogen, which means that the bonding is taken place at the atomic level, resulting in being highly superior in reliability.

As explained above, with the structure as shown above, a high-frequency apparatus such as a voltage controlled oscillator and the like which is small in size and weight, high in performance and low in cost can be realized.

## Claims

1. A high-frequency apparatus comprising a quartz crystal resonator (2) which is directly bonded to a silicon semiconductor substrate (1) by coupling of oxygen and silicon or by coupling of hydrogen or hydroxyl groups whereby the quartz crystal resonator is integrated in a unitary body with the substrate.

2. A high-frequency apparatus comprising a quartz crystal resonator (2) which is bonded to a semiconductor substrate (1) via a glass whereby the quartz crystal resonator is integrated in a unitary body with the substrate.

3. A high-frequency apparatus as claimed in Claim 1 or 2, wherein said semiconductor substrate (1) has at least a transistor (3) formed thereon.

4. A high-frequency apparatus as claimed in Claim 1, 2 or 3 wherein said high-frequency apparatus is a voltage controlled oscillator.

5. A method of producing a high-frequency apparatus comprising a quartz crystal resonator, the method comprising the step of directly bonding a quartz crystal plate to a silicon semiconductor substrate by coupling of oxygen and silicon or by coupling of hydrogen or hydroxyl groups whereby the quartz crystal resonator is integrated in a unitary body with the substrate.

6. A method of producing a high-frequency apparatus comprising a quartz crystal resonator, the method comprising the step of bonding a quartz crystal plate to a semiconductor substrate via glass and including treating the semiconductor substrate and the quartz crystal plate at a temperature below a melting point of the glass, whereby the quartz crystal resonator is integrated in a unitary body with the substrate.

7. A method according to Claim 5 or 6 in which said step of bonding comprises treating the semiconductor substrate and quartz crystal at a temperature of 860°C or less.

8. A method according to Claim 5, 6 or 7 further comprising removing a portion of said semiconductor substrate beneath a central portion of said quartz crystal plate.

9. A method according to Claim 5 or 6 comprising:
thoroughly cleaning surfaces of the semiconductor substrate and quartz crystal plate;
superposing the semiconductor substrate and quartz crystal plate; and
heating the semiconductor substrate and quartz crystal plate at a temperature in the range 300 to 800°C whereby they are directly bonded to each other.

10. A method according to any of Claims 5 to 9 further comprising the step of processing the quartz crystal plate so as to make its thickness 5µm or less.

11. A method according to any of Claims 5 to 10 being a method for the production of a voltage controlled oscillator.

## Revendications

1. Appareil à haute fréquence comprenant un résonateur à cristal de quartz (2) qui est collé directement sur un substrat de semiconducteur de silicium (1) grâce à un couplage d'oxygène et de silicium ou grâce à un couplage d'hydrogène ou de groupements hydroxyles d'où il résulte que le résonateur à cristal de quartz est intégré en un corps solidaire avec le substrat.

2. Appareil à haute fréquence comprenant un résonateur à cristal de quartz (2) qui est collé sur un substrat de semiconducteur (1) par l'intermédiaire d'un verre, d'où il résulte que le résonateur à cristal de quartz est intégré en un corps solidaire avec le substrat.

3. Appareil à haute fréquence selon la revendication 1 ou 2, dans lequel ledit substrat de semiconducteur (1) comporte au moins un transistor (3) formé sur celui-ci.

4. Appareil à haute fréquence selon la revendication 1, 2 ou 3, dans lequel ledit appareil à haute fréquence est un oscillateur commandé en tension.

5. Procédé de fabrication d'un appareil à haute fréquence comprenant un résonateur à cristal de quartz, le procédé comprenant l'étape consistant à coller directement une plaque de cristal de quartz sur un substrat de semiconducteur de silicium par couplage d'oxygène et de silicium ou par couplage d'hydrogène ou de groupements hydroxyles, d'où il résulte que le résonateur à cristal de quartz est intégré en un corps solidaire avec le substrat.

6. Procédé de fabrication d'un appareil à haute fréquence comprenant un résonateur à cristal de quartz, le procédé comprenant l'étape consistant à coller une plaque de cristal de quartz sur un substrat de semiconducteur par l'intermédiaire d'un verre et comprenant le traitement du substrat de semiconducteur et de la plaque de cristal de quartz à une température en-dessous du point de fusion du verre, d'où il résulte que le résonateur à cristal de quartz est intégré en un corps solidaire avec le substrat.

7. Procédé selon la revendication 5 ou 6, dans lequel ladite étape de collage comprend le traitement du substrat de semiconducteur et du cristal de quartz à une température de 860° C ou moins.

8. Procédé selon la revendication 5, 6 ou 7, comprenant en outre l'enlèvement d'une partie du substrat de semiconducteur en-dessous d'une partie centrale de ladite plaque de cristal de quartz.

9. Procédé selon la revendication 5 ou 6, comprenant :
le nettoyage soigné des surfaces du substrat de semiconducteur et de la plaque de cristal de quartz,
la superposition du substrat de semiconducteur et de la plaque de cristal de quartz, et
le chauffage du substrat de semiconducteur et de la plaque de cristal de quartz à une température dans la plage de 300 à 800° C d'où il résulte qu'ils sont directement collés l'un à l'autre.

10. Procédé selon l'une quelconque des revendications 5 à 9, comprenant en outre l'étape consistant à traiter la plaque de cristal de quartz de façon à amener son épaisseur à 5 µm ou moins.

11. Procédé selon l'une quelconque des revendications 5 à 10, qui est un procédé destiné à la fabrication d'un oscillateur commandé en tension.

## Patentansprüche

1. Hochfrequenzvorrichtung mit einem Quarzkristallresonator (2), welcher direkt auf ein Siliziumhalbleitersubstrat (1) gebondet ist, durch Kopplung von Sauerstoff und Silizium oder durch Kopplung von Wasserstoff oder Hydroxylgruppen, wodurch der Quarzkristallresonator als ein einheitlicher Körper mit dem Substrat integriert ist.

2. Hochfrequenzvorrichtung mit einem Quarzkristallresonator (2), welcher auf ein Halbleitersubstrat (1) über ein Glas gebondet ist, wodurch der Quarzkristallresonator als ein einheitlicher Körper mit dem Substrat integriert ist.

3. Hochfrequenzvorrichtung nach den Ansprüchen 1 oder 2, dadurch gekennzeichnet, daß das Halbleitersubstrat (1) mindestens einen darauf ausgebildeten Transistor (3) aufweist.

4. Hochfrequenzvorrichtung nach den Ansprüchen 1, 2 oder 3, dadurch gekennzeichnet, daß die Hochfrequenzvorrichtung ein spannungsgesteuerter Oszillator ist.

5. Verfahren zur Herstellung einer Hochfrequenzvorrichtung mit einem Quarzkristallresonator, wobei das Verfahren den Schritt enthält, daß eine Quarzkristallplatte direkt auf ein Siliziumhalbleitersubstrat gebondet wird, durch Kopplung von Sauerstoff und Silizium oder durch Kopplung von Wasserstoff oder Hydroxylgruppen, wodurch der Quarzkristallresonator als ein einheitlicher Körper mit dem Substrat integriert wird.

6. Verfahren zur Herstellung einer Hochfrequenzvorrichtung mit einem Quarzkristallresonator, wobei das Verfahren den Schritt enthält, daß eine Quarzkristallplatte auf einem Halbleitersubstrat über Glas gebondet wird und das Halbleitersubstrat und die Quarzkristallplatte bei einer Temperatur unterhalb eines Schmelzpunktes des Glases behandelt wird, wodurch der Quarzkristallresonator als ein einheitlicher Körper mit dem Substrat integriert wird.

7. Verfahren gemäß den Ansprüchen 5 oder 6, dadurch gekennzeichnet, daß der Schritt des Bondens die Behandlung des Halbleitersubstrates und des Quarzkristalles bei einer Temperatur von 860° C oder darunter beinhaltet.

8. Verfahren gemäß den Ansprüchen 5, 6 oder 7, dadurch gekennzeichnet, daß ein Abschnitt des Halbleitersubstrates unterhalb eines zentralen Abschnittes der Quarzkristallplatte entfernt wird.

9. Verfahren nach den Ansprüchen 5 oder 6 mit:
Oberflächen des Halbleitersubstrates und der Quarzkristallplatte werden gründlich gereinigt;
das Halbleitersubstrat und die Quarzkristallplatte werden übereinander angeordnet; und
das Halbleitersubstrat und die Quarzkristallplatte werden bei einer Temperatur in dem Bereich von 300 bis 800° C aufgeheizt, wodurch sie direkt aneinander gebondet werden
.

10. Verfahren nach einem der Ansprüche 5 bis 9, gekennzeichnet durch den Schritt der Verarbeitung der Quarzkristallplatte so, daß ihre Dicke 5 µm oder weniger gemacht wird.

11. Verfahren nach einem der Ansprüche 5 bis 10, dadurch gekennzeichnet, daß es ein Verfahren zur Herstellung eines spannungsgesteuerten Oszillators ist.
